# FASCICULE DE BREVET EUROPEEN

(11) **EP 1 818 677 B1**
(45) Date de publication et mention de la délivrance du brevet: **30.03.2011**
(21) Numéro de dépôt: 07101475.7
(22) Date de dépôt: 31.01.2007
(51) Int. Cl.: G01R 31/317, G01R 31/3185

(54) **Circuit électronique comprenant un mode de test sécurisé par rupture d'une chaîne de test**
Elektronischer Schaltkreis, der einen mittels Unterbrechung einer Testkette gesicherten Testmodus umfasst
Electronic circuit comprising a test mode secured by breaking a scan chain

(30) Priorité: 10.02.2006 FR 0601180
(43) Date de publication de la demande: 15.08.2007
(73) Titulaire: STMicroelectronics S.A., 92120 Montrouge (FR)
(72) Inventeur: Bancel, Frédéric Novagraaf Technologies, 57070 METZ (FR); Hely, David Novagraaf Technologies, 57070 METZ (FR)
(74) Mandataire: Bouchet, Geneviève

(56) Documents cités:
- EP-A1- 1 560 031
- WO-A-2007/017839
- US-A1- 2003 204 801
- US-B1- 6 499 124
- HELY D ET AL: "Scan design and secure chip" ON-LINE TESTING SYMPOSIUM, 2004. IOLTS 2004. PROCEEDINGS. 10TH IEEE IN TERNATIONAL FUNCHAL, MADEIRA ISLAND, PORTUGAL 12-14 JULY 2004, PISCATAWAY, NJ, USA,IEEE LNKD- DOI:10.1109/OLT.2004.1319691, 12 July 2004 (2004-07-12), pages 219-224, XP010714290 ISBN: 978-0-7695-2180-0

## Description

L'invention concerne, de façon générale, les circuits électroniques intégrés synchrones munis de moyens de logique combinatoire, de bascules, et de moyens de test.

Plus précisément, l'invention concerne un circuit électronique comprenant une pluralité de cellules configurables susceptibles d'être configurées, en fonction d'un signal de commande de chaînage :
- dans un état fonctionnel dans lequel les cellules configurables sont fonctionnellement reliées à des cellules logiques avec lesquelles elles coopèrent pour former au moins un circuit logique, ou
- dans un état chaîné dans lequel les cellules configurables sont fonctionnellement connectées en chaîne pour former un registre à décalage.

Il est aujourd'hui bien connu de vérifier le fonctionnement correct des éléments fonctionnels d'un circuit intégré en imposant et / ou en déterminant, à des instants prédéfinis, des valeurs de données présentes en certains points internes de ce circuit intégré. Une telle technique de test des chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973".

Selon cette technique, chacune des bascules du circuit logique, dont il est utile de connaître l'état et / ou d'imposer le contenu durant le fonctionnement standard du circuit intégré, est dotée à son entrée d'un multiplexeur. Les différentes bascules et les multiplexeurs qui leur sont associés constituent ainsi autant de cellules configurables dont les accès sont contrôlés par ces multiplexeurs.

Les multiplexeurs de ces différentes cellules configurables sont collectivement commandés par un contrôleur d'accès ou "contrôleur TAP" ("TAP" pour "Test Access Port" en langue anglaise) qui, en fonction d'un signal de commande définissant un mode de fonctionnement choisi, utilise cet ensemble de cellules configurables soit comme un circuit fonctionnel standard, intégré au circuit logique qu'il forme avec les cellules logiques, soit comme un circuit de test.

Pour ce faire, le contrôleur TAP reçoit sur différents conducteurs de commande, et / ou adresse sur différents conducteurs de commande par lesquels il est relié aux différentes cellules configurables, des signaux de commande, tels qu'un signal de commande de mode, un signal de commande de chaînage ou encore un signal de commande de propagation de données, qui autorisent à modifier et / ou modifient les chemins de circulation des données au sein du circuit intégré et qui permettent ainsi la capture de ces données par le contrôleur, en vue de leur analyse ultérieure.

En mode de fonctionnement standard, le contrôleur TAP pilote donc les multiplexeurs des cellules configurables de manière que les bascules de ces cellules soient connectées à des cellules logiques environnantes pour définir un ou plusieurs sous-ensembles fonctionnels du circuit intégré.

Dans le mode de test, qui est normalement déclenché à réception par le contrôleur TAP d'un signal de commande de passage en mode de test, ce contrôleur produit un signal de commande de chaînage pour connecter en série les bascules des cellules configurables de manière à former un registre à décalage.

Ce registre comporte notamment une entrée série et une sortie série respectivement connectées à une sortie et à une entrée du contrôleur TAP, ainsi qu'une entrée d'horloge recevant un signal de propagation pour cadencer le flot de données circulant dans le registre à décalage.

Dans un premier temps, le contrôleur TAP charge en série des données dans les bascules des cellules configurables par l'entrée du registre à décalage que forment ces cellules configurables.

Puis, le contrôleur TAP change la commutation des multiplexeurs pour former le circuit fonctionnel, et commande l'exécution d'un ou plusieurs cycles du signal de propagation par ce circuit fonctionnel. Dans cette phase, les données chargées dans les bascules des cellules configurables sont traitées par le circuit fonctionnel.

Le contrôleur change alors une nouvelle fois la commutation des multiplexeurs pour former à nouveau le registre à décalage et récupère, en série sur la sortie de ce registre à décalage, les données mémorisées dans les bascules des cellules configurables durant le dernier cycle du signal de propagation.

En dépit de l'intérêt confirmé de cette technique de test, son application pratique peut en certaines circonstances s'avérer problématique, notamment sur les circuits intégrés qui traitent des données secrètes.

En effet, dans la mesure où l'activation du mode de test peut permettre à un fraudeur de lire le contenu des bascules des cellules configurables, cette technique de test présente a priori l'inconvénient de rendre de tels circuits très vulnérables à une utilisation frauduleuse.

Par exemple, en stoppant à divers moments un processus de chargement interne de données secrètes dans le circuit intégré et en déchargeant le contenu du registre à décalage, un fraudeur pourra obtenir des informations sur des données secrètes, voire les reconstituer.

En activant le mode de test, un fraudeur pourra également accéder en écriture aux bascules des cellules configurables pour insérer des données frauduleuses, ou bien pour placer le circuit intégré dans une configuration non autorisée. Il pourra ainsi par exemple accéder à un registre contrôlant un organe sécuritaire tel qu'un capteur pour le désactiver. Il pourra également injecter une donnée erronée en vue d'obtenir de l'information sur une donnée secrète.

La fraude peut en fait adopter deux stratégies différentes: la première consiste à prendre le contrôle du contrôleur TAP et à observer sur les plots externes le contenu des cellules du registre à décalage ; la seconde consiste à prendre le contrôle des cellules configurables en les excitant par micro-sondage de manière à simuler le pilotage de ces cellules par les signaux de commande qu'émet le contrôleur TAP.

On connaît notamment du document D1 (demande EP 1 560 031) un circuit électronique conçu pour faire échec à une tentative de fraude conforme à la deuxième stratégie. Dans D1, le circuit électronique comprend un module de contrôle de connexion approprié pour, en fonction d'une clé d'identification :
- chaîner les cellules configurables dans un ordre prédéterminé pour former le registre à décalage de test si la clé d'identification est valide, ou
- chaîner les cellules configurables dans un ordre aléatoire pour former un circuit de diversion sinon ; le circuit de diversion étant constitué des mêmes cellules configurables connectées entre elles dans un ordre différent de l'ordre prédéterminé et choisi aléatoirement à chaque formation d'un circuit de diversion.

Ainsi, dans le circuit de D1, si on essaye de former le registre à décalage pour inscrire ou lire frauduleusement des données (c'est-à-dire sans s'identifier correctement), les données sont en fait écrites ou lues dans un circuit de diversion. Ces données n'auront ainsi soit pas l'effet attendu sur le circuit logique, soit n'auront aucune signification lors de la lecture. Ainsi, la récupération frauduleuse d'une clé secrète qui serait mémorisée dans le circuit logique devient impossible.

Un inconvénient du circuit de D1 est le fait que, pour être vraiment efficace, il est nécessaire d'utiliser dans le module de contrôle de connexion des multiplexeurs de très grande taille, ayant un très grand nombre d'entrées afin de pouvoir réaliser un grand nombre de circuits de diversion différents. La sécurité du circuit est en effet proportionnelle au nombre de circuits de diversion qu'il est possible de réaliser aléatoirement. L'utilisation de multiplexeurs de grande taille entraîne d'une part une réalisation difficile du circuit et d'autre part une consommation importante du circuit, y compris dans le mode de fonctionnement standard. Egalement, l'efficacité du circuit de D1 augmente avec la fréquence de reconnexion des circuits de diversion, mais augmenter cette fréquence augmente également de manière significative la consommation du circuit. Enfin, les données contenues dans un circuit de diversion sont les données contenues dans le registre à décalage de test. Aussi, mêmes si ces données sont mélangées lors de la formation du circuit de diversion, il y a cependant un risque que ces données soient récupérées et exploitées par un fraudeur.

L'invention a pour but de proposer un circuit aussi protégé que le circuit de D1 contre les attaques par micro-sondage, mais plus simple, plus facile à réaliser.

Ce but est atteint par le circuit de la revendication 1.

Le circuit électronique selon l'invention comprend, de même que les circuits antérieurs connus, des cellules configurables comprenant une entrée de test et une sortie, les cellules configurables étant susceptibles d'être connectées entre elles en chaîne dans un ordre prédéfini par l'intermédiaire de leur entrée de test et de leur sortie pour former un registre à décalage de test si elles reçoivent un signal de commande de chaînage.

Le circuit selon l'invention comprend également un module de contrôle de connexion comprenant un module d'identification adapté pour recevoir une clé d'identification et pour produire un signal de validation si la clé est valide, et pour, si la clé d'identification est non valide, déconnecter l'entrée de test d'au moins une cellule configurable. Le module de contrôle de connexion comprend en outre au moins un multiplexeur associé à la cellule configurable à déconnecter et présentant :
- une entrée de formation du registre à décalage connectée à une sortie d'une cellule configurable précédant la cellule configurable à déconnecter,
- une entrée de données,
- une sortie connectée à l'entrée de test de la cellule configurable à déconnecter, et
- une entrée de sélection connectée à une sortie du module d'identification.

Le multiplexeur est adapté pour, si la clé est non valide
- maintenir déconnectée l'entrée de test de la dite au moins une cellule configurable, ou
- connecter l'entrée de test de la dite au moins une cellule configurable à une sortie d'un générateur de données aléatoires dudit module de contrôle,
de sorte que, à la réception du signal de commande de chainage, le registre à décalage de test ne soit pas correctement formé.

Ainsi, si le module de connexion reçoit une clé d'identification non valide ou ne reçoit pas de clé d'identification, il déconnecte l'entrée de test d'au moins une cellule configurable de la sortie de la cellule configurable précédente et il empêche ainsi la formation correcte du registre à décalage de test. De plus, l'entrée de test déconnectée est maintenue déconnectée, connectée à une source de potentiel constant ou connectée à la sortie d'un générateur aléatoire. Ainsi, la cellule configurable qui a été déconnectée de la sortie de la cellule configurable précédente reçoit des données totalement indépendantes des données éventuellement encore contenues dans le registre à décalage de test. Il est donc impossible d'inscrire ou de lire correctement des données dans le registre de décalage de test.

De préférence, le module de contrôle de connexion est adapté pour déconnecter l'entrée de test de plusieurs cellules configurables s'il reçoit une clé d'identification non valide.

La sécurité du circuit augmente en effet avec le nombre de cellules configurables susceptibles d'être déconnectées par le module de contrôle de connexion. Dans la pratique, le nombre de cellules configurables susceptibles d'être déconnectées est un compromis entre d'une part la sécurité du circuit et d'autre part la complexité et la difficulté de réalisation du circuit, tous ces paramètres augmentant avec le nombre de cellules susceptibles d'être déconnectées.

Les cellules susceptibles d'être déconnectées peuvent être par exemple régulièrement réparties sur l'ensemble des cellules configurables. Les autres cellules configurables restent connectées entre elles par l'intermédiaire de leur entrée de test et de leur sortie.

Toutefois, il est préférable de choisir des cellules susceptibles d'être déconnectées de manière aléatoire parmi l'ensemble des cellules configurables. Il devient ainsi plus difficile pour un fraudeur de trouver parmi les cellules configurables celles qui sont susceptibles d'être déconnectées. La sécurité du circuit est ainsi augmentée.

De préférence encore, le module de contrôle de connexion est également adapté pour appliquer des données aléatoires sur l'entrée de test de la (ou des) cellule(s) configurable(s) déconnectée(s). Un tel module de contrôle permet ainsi d'inscrire du bruit (les données aléatoires) dans les cellules configurables encore connectées.

Ainsi, un fraudeur qui tenterait d'inscrire ou de lire des données dans les cellules configurables sans s'être correctement identifié au préalable, inscrirait ou lirait pour l'essentiel des données aléatoires, qui n'auront soit pas l'effet attendu sur le circuit logique, soit pas de signification lors de la lecture. Les données aléatoires ont par ailleurs pour effet de leurrer le fraudeur qui a l'impression d'avoir accès à la totalité du registre de test.

S'il reçoit le signal de validation, le multiplexeur reproduit sur sa sortie l'état de son entrée de formation du registre à décalage. Au contraire, s'il ne reçoit pas le signal de validation, le multiplexeur reproduit sur sa sortie d'état de son entrée de donnée.

L'entrée de données du multiplexeur peut rester non connectée, ou connectée à un potentiel constant.

Toutefois, le module de contrôle de connexion comprend de préférence également un générateur de données aléatoires dont une sortie est connectée à l'entrée de données du multiplexeur.

S'il et envisagé de déconnecter plusieurs cellules configurables, le module de contrôle de connexion comprend plusieurs multiplexeurs, chacun associé respectivement à une des cellules configurables à déconnecter.

La réalisation des cellules configurables est connue en soi. Elle sera détaillée plus loin.

Le circuit selon l'invention peut également comprendre un circuit de commande tel qu'un contrôleur TAP pour produire les signaux de commande nécessaires à la lecture et à l'écriture dans le registre à décalage de test, notamment le signal de commande de chaînage et le signal de propagation de données. Toutefois, ces signaux peuvent également être produits par un contrôleur TAP externe au circuit de l'invention et connecté à une interface d'entrée / sortie du circuit de l'invention.

Si le contrôleur TAP est interne au circuit électronique, on pourra choisir d'inclure ou non le module de contrôle de connexion dans ce contrôleur TAP.

L'invention concerne également une carte à puce comportant un circuit électronique tel que décrit ci-dessus.

L'invention sera mieux comprise et d'autres caractéristiques et avantages apparaîtront à la lecture de la description qui va suivre, d'exemples de mise en oeuvre d'un circuit électronique selon l'invention. La description, faite à titre indicatif et nullement limitatif, est à lire en relation aux dessins annexés dans lesquels :
- la figure 1 est un schéma d'un premier mode de réalisation d'un circuit selon l'invention,
- la figure 2 est un schéma d'un deuxième mode de réalisation d'un circuit selon l'invention.

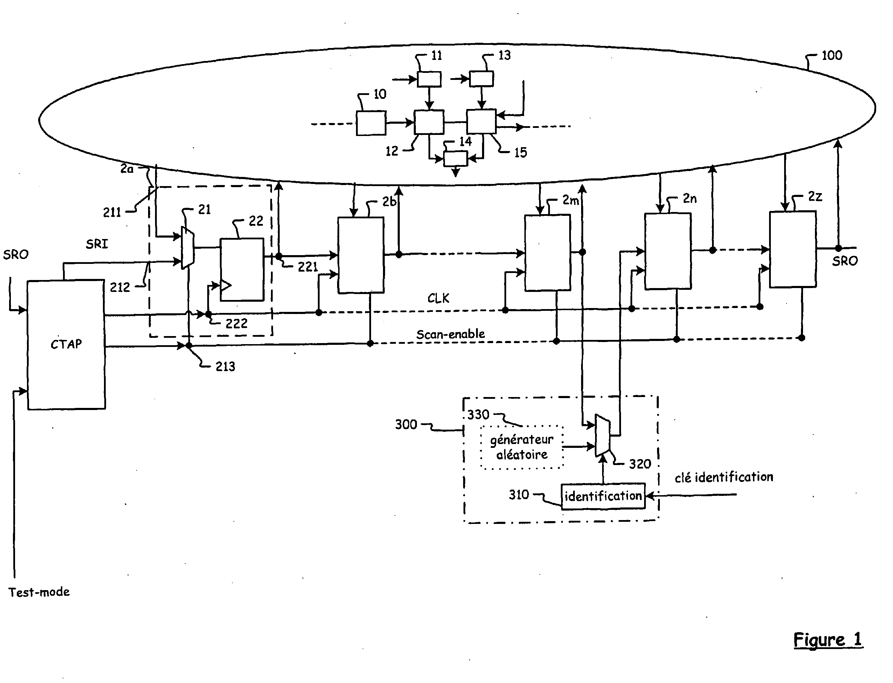

La figure 1 illustre un premier exemple d'un circuit électronique 1 selon l'invention.

Le circuit 1 est un circuit intégré comprenant, de même qu'un circuit antérieur, un circuit logique 100 comprenant une pluralité de cellules logiques 10 à 15. Le circuit 1 comprend également des cellules configurables 2a, 2b, ..., 2m, 2n, ..., 2z, susceptibles d'être connectées aux cellules logiques pour former au moins un circuit fonctionnel, susceptibles d'être connectées entre elles pour former un registre à décalage de test, et susceptibles de recevoir des signaux de commande, notamment un signal de commande de chaînage SCAN_ENABLE et un signal de propagation de données CLK pour inscrire ou lire des données dans les cellules configurables.

Les cellules configurables sont connues en soi et sont toutes identiques. Aussi, seule la première cellule 2a est détaillée sur la figure 1. Une cellule configurable comprend typiquement une entrée fonctionnelle connectée au circuit logique 100, une entrée de test connectée à une sortie d'une cellule précédente, l'entrée de test de la première cellule 2a formant l'entrée SRI du registre de test sur laquelle sont susceptibles d'être appliquées des données à charger dans le registre de test, une entrée de commande de chaînage pour recevoir le signal SCAN_ENABLE, une entrée de commande de propagation pour recevoir le signal CLK et une sortie connectée d'une part au circuit de logique 100 et d'autre part à l'entrée de données d'une cellule configurable suivante, la sortie de la dernière cellule configurable 2z formant la sortie de données SRO du registre de test. Une cellule configurable comprend typiquement un multiplexeur 21 et une bascule D 22.

Une première entrée 211 du multiplexeur 21 forme l'entrée fonctionnelle de la cellule configurable, et une deuxième entrée 212 du multiplexeur 21 forme l'entrée de test de la cellule configurable. Un plot de sélection 213 du multiplexeur 21 forme l'entrée de commande de chaînage de la cellule configurable et permet de reproduire sélectivement sur la sortie du multiplexeur, soit l'état de sa première entrée soit l'état de sa deuxième entrée. Une sortie du multiplexeur 21 est connectée à une entrée de données de la bascule D 22. Une sortie 221 de la bascule 22 forme la sortie de données de la cellule configurable et est connectée d'une part au circuit de logique 100 et d'autre part à la deuxième entrée 212 du multiplexeur 21 de la cellule configurable suivante, la sortie de donnée 221 de la bascule 22 de la dernière cellule configurable 2z formant quant à elle la sortie SRO du registre de test.

La bascule D présente également une entrée d'horloge 222 formant l'entrée de commande de propagation de la cellule configurable pour recevoir le signal de propagation de données. La bascule D peut éventuellement être commandée en mode de test à une fréquence de test différente de la fréquence de fonctionnement normal du circuit 100.

Selon l'état de la technique, le plot 213 reçoit typiquement un signal de commande de chaînage nommé SCAN_ENABLE fourni de façon connue en soi par un contrôleur TAP. Comme décrit dans l'introduction, on réalise un test de chemin interne du circuit logique 100 en appliquant initialement un signal SCAN_ENABLE sur le plot 213 des multiplexeurs. Les cellules configurables sont alors toutes chaînées pour former un registre à décalage de test. On charge alors ce registre à décalage avec les données appliquées à son entrée SRI (qui correspond à la deuxième entrée 212 du multiplexeur de la première cellule configurable 2a), le chargement étant cadencé par le signal de propagation de données CLK. On arrête ensuite l'application du signal SCAN_ENABLE sur le plot 213 pour former un circuit fonctionnel dans lequel les cellules configurables sont connectées aux cellules logiques. Le circuit fonctionnel réalise un ou plusieurs cycles d'horloge avec les données chargées. On applique ensuite de nouveau le signal SCAN ENABLE pour former le registre de test et on lit alors les données inscrites dans le registre de test sur sa sortie SRO, qui correspond à la sortie de la bascule 22 de la dernière cellule configurable.

L'invention vise notamment à protéger le circuit électronique contre une attaque par microsondage. Une telle attaque peut consister à appliquer une microsonde sur une commande des plots 213 pour former frauduleusement le registre de décalage de test et à appliquer une autre microsonde pour inscrire ou lire des données dans ce registre de test.

Selon l'invention, le circuit électronique comprend également un module de contrôle de connexion 300 pour déconnecter l'entrée de test d'au moins une cellule configurable si le module de contrôle de connexion reçoit une clé d'identification non valide, et adapté pour :
- laisser déconnectée l'entrée de test de la dite au moins une cellule configurable, ou
- appliquer un potentiel constant sur l'entrée de test de la dite au moins une cellule configurable, ou
- connecter l'entrée de test de la dite au moins une cellule configurable à une sortie d'un générateur de données aléatoires.

Le module de contrôle de connexion 300 comprend une entrée 301 de réception d'une clé d'identification. Cette clé d'identification peut se présenter sous la forme d'un mot ayant un nombre de bits approprié. Si une clé correcte est appliquée sur l'entrée 301, le module de contrôle 300 est inactif et les cellules configurables sont soit connectées en chaîne si elles reçoivent le signal SCAN_ENABLE soit connectées aux cellules logiques sinon.

Si aucune clé d'identification n'est appliquée sur l'entrée 301 ou si une clé d'identification erronée est appliquée, le module 300 déconnecte l'entrée de test d'au moins une cellule configurable, de sorte que, si les cellules reçoivent un signal de commande de chaînage SCAN_ENABLE, le registre de test n'est pas correctement formé.

La figure 1 illustre de façon détaillée un exemple de réalisation d'un module de contrôle selon l'invention, approprié dans l'exemple pour déconnecter l'entrée de test de la cellule 2n de la sortie de la cellule 2m.

A cet effet, le module de contrôle de connexion comprend un module d'identification 310 et un multiplexeur 320.

Le module d'identification 310 comprend une entrée susceptible de recevoir une clé d'identification et une sortie sur laquelle il produit un signal de validation VAL s'il reçoit une clé d'identification valide. Le module d'identification 310 n'est pas détaillé sur la figure 1. Il peut par exemple comprendre un comparateur comprenant une entrée connectée à l'entrée du module d'identification, une entrée sur laquelle est appliquée une clé de référence (qui est par exemple un mot de données mémorisé dans un registre du circuit électronique), et une sortie connectée à la sortie du module d'identification.

Le multiplexeur 320 comprend une entrée de formation d'un registre de test connectée à la sortie de la cellule 2m, une entrée de données, une entrée de sélection connectée à la sortie du module d'identification et une sortie connectée à l'entrée de test de la cellule 2n. En présence du signal de validation, le multiplexeur 320 reproduit sur sa sortie l'état de son entrée de formation du registre de test. Au contraire, en l'absence du signal de validation (clé d'identification non valide ou non fournie), le multiplexeur 320 reproduit sur sa sortie l'état de son entrée de donnée.

Dans l'exemple de la figure 1, le module de contrôle de connexion 300 est également adapté pour appliquer des données aléatoires sur l'entrée de test de la cellule configurable déconnectée 2n.

A cet effet, le module de contrôle de connexion comprend un générateur 330 de données aléatoires dont une sortie est connectée à l'entrée de données du multiplexeur.

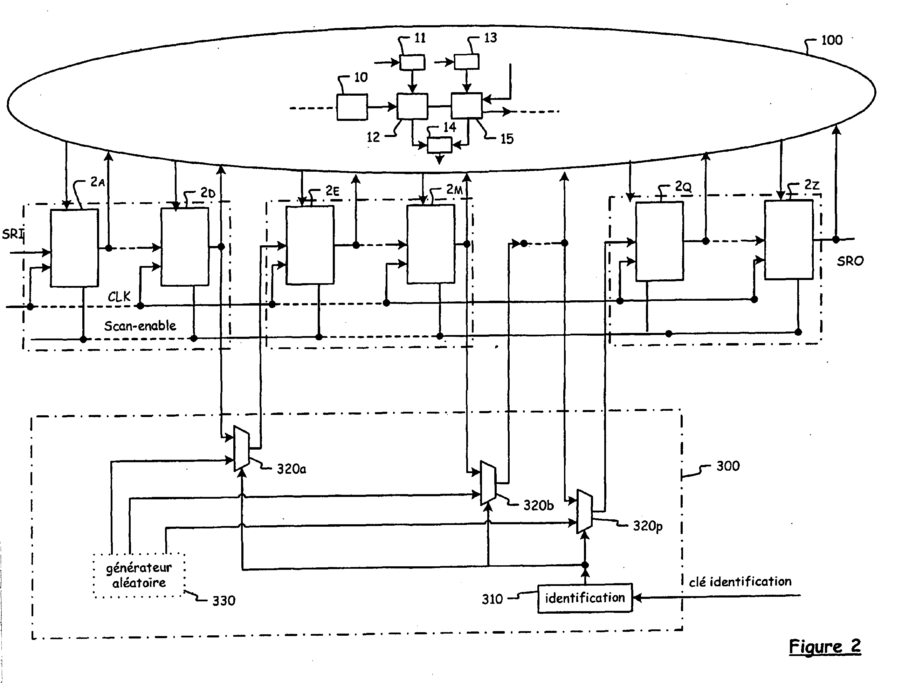

La figure 2 illustre un deuxième exemple de réalisation du circuit électronique selon l'invention.

Dans ce deuxième exemple, le module de contrôle de connexion est adapté pour déconnecter l'entrée de test de plusieurs cellules configurables et pour appliquer sur les entrées de test des cellules déconnectées des données aléatoires.

D'un point de vue pratique, dans cet exemple, les cellules configurables ont été séparées en X segments comprenant chacun un nombre variable de cellules configurables associées en série. Le premier segment comprend les cellules 2a à 2d, le deuxième segment comprend les cellules 2e à 2m, ..., et le dernier segment comprend les cellules 2q à 2z. Dans chaque segment, les cellules sont associées en série par l'intermédiaire de leur entrée de test 212 et de leur sortie 221.

Le module de contrôle de connexion comprend un nombre de multiplexeurs 320a à 320p égal au nombre de segments moins un (X - 1). Il comprend également un module d'identification 310 et un générateur de données aléatoires 330.

Les entrées de formation du registre de test des multiplexeurs 320a à 320p sont connectées respectivement à la sortie de données de la dernière cellule configurable du premier segment, du deuxième segment, ..., et du dernier segment. Les entrées de données des multiplexeurs 320a à 320p sont connectées respectivement à des sorties de données du générateur 330. Les sorties des multiplexeurs 320a à 320p sont connectées respectivement à l'entrée de test de la première cellule configurable du deuxième segment, du troisième segment, ..., et du dernier segment. Enfin, les entrées de sélection de tous les multiplexeurs 320a à 320p sont connectées ensembles à la sortie du module d'identification 310.

## Revendications

1. Circuit électronique comprenant des cellules configurables comprenant une entrée de test et une sortie, les cellules configurables (2a, ... ,2z) étant susceptibles d'être connectées entre elles en chaîne dans un ordre prédéfini par l'intermédiaire de leur entrée de test (212) et de leur sortie pour former un registre à décalage de test si elles reçoivent un signal de commande de chaînage, le circuit électronique comprenant également un module de contrôle de connexion (300) comprenant un module d'identification (310) comprenant une entrée pour recevoir une clé d'identification et une sortie pour produire un signal de validation, ledit module comprenant un comparateur comprenant une entrée connectée à l'entrée du module d'identification, une entrée pour recevoir une clé de référence et une sortie connectée à la sortie du module d'identification pour produire un signal de validation si la clé est valide par comparaison avec la clé de référence, le module de contrôle de connexion comprenant en outre au moins un multiplexeur associé à la cellule configurable à déconnecter et présentant :
✔ une entrée de formation du registre à décalage connectée à une sortie d'une cellule configurable précédant la cellule configurable à déconnecter,
✔ une entrée de données,
✔ une sortie connectée à l'entrée de test de la cellule configurable à déconnecter, et caratérisé en ce que le multiplexeur comprend
✔ une entrée de sélection connectée directement à la sortie du module d'identification,
le multiplexeur étant adapté pour, en présence du signal de validation, reproduire sur sa sortie l'état de son entrée de formation et, en l'absence du signal de validation, reproduire sur sa sortie l'état de son entrée de données et :
le module de connexion étant adapté pour:
• maintenir déconnectée ladite entrée de données, ou connecter ladite entrée de données à un potentiel constant, ou
• connecter ladite entrée de données à une sortie d'un générateur de données aléatoires (330) dudit module de contrôle,
de sorte que, à la réception du signal de commande de chainage, le registre à décalage de test ne soit pas correctement formé.

2. Circuit électronique selon la revendication 1, dans lequel le module de contrôle de connexion est adapté pour déconnecter l'entrée de test de plusieurs cellules configurables s'il reçoit une clé d'identification non valide.

3. Circuit selon la revendication 2, dans lequel le module de contrôle de connexion comprend plusieurs multiplexeurs, chacun associé respectivement à une des cellules configurables à déconnecter.

4. Circuit selon la revendication 2, dans lequel les cellules configurables à déconnecter sont régulièrement réparties dans le registre à décalage.

5. Circuit selon la revendication 2, dans lequel les cellules configurables à déconnecter sont choisies aléatoirement parmi l'ensemble des cellules configurable.

6. Carte à puce comportant un circuit électronique selon l'une des revendications précédentes.

## Claims

1. Electronic circuit comprising configurable cells comprising a test input and an output, the configurable cells (2a,...2z) being capable of being connected to one another in a chain in a predefined order by means of their test input (212) and their output to form a test shift register if they receive a chaining command signal, the electronic circuit also comprising a connection control module (300) comprising an identification module (310) comprising an input to receive an identification key and an output to produce an enable signal, said module comprising a comparator comprising an input connected to the input of the identification module, an input to receive a reference key and an output connected to the output of the identification module to produce an enable signal if the key is valid by comparison with the reference key, the connection control module moreover comprising at least one multiplexer associated with a configurable cell to be disconnected and having:
✔ an input for the formation of the shift register, connected to an output of a configurable cell preceding the configurable cell to be disconnected,
✔ a data input,
✔ an output connected to the test input of the configurable cell to be disconnected, and
**characterized in that** the multiplexer comprises
✔ a selection input directly connected to the output of the identification module,
the multiplexer being adapted to reproducing at its output, in the presence of the enable signal, the state of its formation input and reproducing at its output, in the absence of the enable signal, the state of its data input, and
the connection module being adapted to:
• keeping said data input disconnected or
• connecting said data input to a constant potential, or
• connecting said data input to an output of a random data generator (330) of said control module,
so that, at the reception of the chaining command signal, the test shift register is not correctly formed.

2. Electronic circuit according to claim 1, wherein the connection control module is adapted to disconnecting the test input of several configurable cells if it receives an invalid identification key.

3. Circuit according to claim 2, wherein the connection control module comprises several multiplexers, each associated respectively with one of the configurable cells to be disconnected.

4. Circuit according to claim 2, wherein the configurable cells to be disconnected are evenly distributed in the shift register.

5. Circuit according to claim 2, wherein the configurable cells to be disconnected are chosen randomly from among all the configurable cells.

6. Chip card comprising an electronic circuit according to one of the above claims.

## Patentansprüche

1. Elektronischer Schaltkreis mit konfigurierbaren Zellen, umfassend einen Testeingang und einen Ausgang, wobei die konfigurierbaren Zellen (2a, ... ,2z) in der Lage sind, untereinander in Reihe in einer vorbestimmten Reihenfolge verbunden zu werden, unter Zwischenschaltung ihres Testeingangs (212) und ihres Ausgangs, um ein Test-Schieberegister zu bilden, wenn sie ein Verkettungssteuersignal erhalten, wobei der elektronische Schaltkreis weiterhin ein Verbindungssteuermodul (300) umfasst, das ein Identifizierungsmodul (310) aufweist, das einen Eingang umfasst, um einen Identifizierungsschlüssel zu empfangen, und einen Ausgang, um ein Validierungssignal zu erzeugen, wobei das genannte Modul einen Komparator umfasst, der einen Eingang aufweist, der an den Eingang des Identifizierungsmoduls angeschlossen ist, einen Eingang, um einen Referenzschlüssel zu empfangen, und einen Ausgang, der an den Ausgang des Identifizierungsmoduls angeschlossen ist, um ein Validierungssignal zu erzeugen, wenn der Schlüssel gültig ist, durch Vergleich mit dem Referenzschlüssel, wobei das Verbindungssteuermodul außerdem zumindest einen Multiplexer aufweist, der der konfigurierbaren Zelle, die zu entkoppeln ist, zugeordnet ist und aufweist:
einen Eingang zur Bildung des Schieberegisters, der an einen Ausgang einer konfigurierbaren Zelle angeschlossen ist, die der konfigurierbaren Zelle, die zu entkoppeln ist, vorausgeht,
einen Dateneingang,
einen Ausgang, der mit dem Testeingang der konfigurierbaren Zelle, die zu entkoppeln ist, verbunden ist, und
**dadurch gekennzeichnet, dass** der Multiplexer einen Selektionseingang aufweist, der unmittelbar an den Ausgang des Identifizierungsmoduls angeschlossen ist, wobei der Multiplexer angepasst ist, um in Anwesenheit des Validierungssignals auf seinem Ausgang den Status seines Bildungseingangs zu reproduzieren und in Abwesenheit des Validierungssignals auf seinem Ausgang den Status seines Dateneingangs zu reproduzieren und:
wobei das Verbindungsmodul angepasst ist, um
• den genannten Dateneingang entkoppelt zu halten, oder
• den genannten Dateneingang mit einem konstanten Potential zu verbinden,
oder
• den genannten Dateneingang mit einem Ausgang eines Zufalls-Datengenerators (330) des genannten Steuermoduls zu verbinden,
auf eine Weise, dass bei Empfang des Verkettungssteuersignals das Test-Schieberegister nicht korrekt gebildet ist.

2. Elektronischer Schaltkreis nach Anspruch 1, **dadurch gekennzeichnet, dass** das Verbindungssteuermodul angepasst ist, um den Testeingang von mehreren konfigurierbaren Zellen zu entkoppeln, wenn es einen nicht gültigen Identifizierungsschlüssel erhält.

3. Schaltkreis nach Anspruch 2, **dadurch gekennzeichnet, dass** das Verbindungssteuermodul mehrere Multiplexer umfasst, von denen jeder einer konfigurierbaren Zelle, die zu entkoppeln ist, zugeordnet ist.

4. Schaltkreis nach Anspruch 2, **dadurch gekennzeichnet, dass** die konfigurierbaren Zellen, die zu entkoppeln sind, in dem Schieberegister regelmäßig verteilt sind.

5. Schaltkreis nach Anspruch 2, **dadurch gekennzeichnet, dass** die konfigurierbaren Zellen, die zu entkoppeln sind, unter der Gesamtheit der konfigurierbaren Zellen zufällig ausgewählt sind.

6. Chipkarte mit einem elektronischen Schaltkreis nach einem der vorangehenden Ansprüche.
